# EUROPEAN PATENT SPECIFICATION

(11) **EP 3 441 794 B1**
(45) Date of publication and mention of the grant of the patent: **28.07.2021**
(21) Application number: 17778719.9
(22) Date of filing: 31.03.2017
(51) Int. Cl.: G01V 3/40, G01W 1/10

(54) **DEVICE AND METHOD FOR OBTAINING LOCAL GEOMAGNETIC DISTURBANCES AT MID-LATITUDES**
VORRICHTUNG UND VERFAHREN ZUM ERHALT LOKALER GEOMAGNETISCHER STÖRUNGEN IN MITTLEREN BREITENGRADEN
DISPOSITIF ET PROCÉDÉ D'OBTENTION DE LA PERTURBATION GÉOMAGNÉTIQUE LOCALE À DES LATITUDES MOYENNES

(30) Priority: 05.04.2016 ES 201600258
(43) Date of publication of application: 13.02.2019
(73) Proprietor: Universidad de Alcalá, 28801 Alcala de Henares (Madrid) (ES)
(72) Inventor: GUERRERO ORTEGA, Antonio, 28801 Alcalá De Henares (Madrid) (ES); CID TORTUERO, Consuelo, 28801 Alcalá De Henares (Madrid) (ES); SAIZ VILLANUEVA, María Elena, 28801 Alcalá De Henares (Madrid) (ES); PALACIOS HERNÁNDEZ, Judith, 28801 Alcalá De Henares (Madrid) (ES); CERRATO MONTALBÁN, Yolanda, 28801 Alcalá De Henares (Madrid) (ES)
(74) Representative: Pons
(86) International application number: PCT/ES2017/070189
(87) International publication number: WO 2017/174843

(56) References cited:
- CN-A- 103 115 624
- KR-B1- 101 539 036
- HANS GLEISNER ET AL: "A neural network-based local model for prediction of geomagnetic disturbances", JOURNAL OF GEOPHYSICAL RESEARCH, vol. 106, no. A5, 1 May 2001 (2001-05-01), pages 8425-8433, XP055427719, US ISSN: 0148-0227, DOI: 10.1029/2000JA900142
- WEN-YAO XU ET AL: "Decomposition of daily geomagnetic variations by using method of natural orthogonal component", JOURNAL OF GEOPHYSICAL RESEARCH, vol. 109, no. A5, 25 May 2004 (2004-05-25) , XP055640139, US ISSN: 0148-0227, DOI: 10.1029/2003JA010216
- GLEISNER, H et al.: "A neural network-based local model for prediction of geomagnetic disturbances", J. Geophys. Res., vol. 106, no. A5 1 May 2001 (2001-05-01), pages 8425-8433, XP055427719, Retrieved from the Internet: URL:https://doi.org/10.1029/2000JA900142 [retrieved on 2017-06-20]
- CLUA DE GONZALEZ et al.: "Local-time variations of geomagnetic disturbances during intense geomagnetic storms and possible association with their interplanetary causes", Advances in Space Research, vol. 51, no. 10 2013, pages 1924-1933, XP055547309, ISSN: 0273-1177 Retrieved from the Internet: URL:DOI: 10.1016/j.asr.2012.10.029 [retrieved on 2017-06-20]

## Description

### TECHNICAL FIELD

The present invention is included in the technical field of devices and methods for producing geomagnetic indices with space weather purposes; more particularly, the invention refers to the indices which provide a measurement of the geomagnetic disturbance caused in a localized area on the Earth's surface by sources being external to the planet. The disclosed technique is capable of providing high resolution and real time information about the geomagnetic disturbance at middle latitudes (about 40º).

### STATE OF THE ART

### Technical problem to be solved

It is known that the Sun has a continuous activity which affects life on Earth. The most evident sign of the effect the Sun produces on the planet is the energy that reaches its surface in about 8 minutes in the form of electromagnetic radiation, distributed in different ranges of the electromagnetic spectrum, although the highest contribution is found in the visible one.

As well as radiation, the solar corona is continuously emitting a flow of charged particles, known as solar wind, which is in a plasma state and travels across interplanetary space linked to the solar magnetic field itself, interacting with all the planets, comets and asteroids that are within the heliosphere. At the typical speed of 400 km/s, this magnetized plasma reaches the Earth in about 4 days and it interacts with the Earth's dipole magnetic field, distorting it. The interaction results in a complex system of plasma convection movements and electric currents inside the terrestrial magnetosphere which lead to the complete topology that this acquires as a balance or "quiet state" situation.

However, in the Sun, as a highly dynamic star with cyclical activity of about 11 years, explosive and violent phenomena also occur sporadically in the self-sustaining magnetic structures and plasma, leading to different types of phenomena such as: flares, prominences, Coronal Mass Ejection (CME), etc. In those a huge amount of energy, plasma and magnetic field is released which can significantly affect the terrestrial environment when approaching the Earth. Likewise, fast solar wind (referred to as High Speed Stream or HSS) released from solar structures with longer half-life than the CMEs, known as Coronal Holes (CH), can also produce significant effects in the terrestrial environment.

To this already complicated scenario being presented, it must be added that high energy particles can also be produced (of the order of MeV) travelling at almost relativistic speeds and taking just a few hours to reach the Earth. This is known as Solar Energetic Particles (SEP), being produced in the solar flares or in the shock waves of the CMEs. Particles from an extra solar origin, the so-called cosmic rays, have to be added to these solar-origin particle events, the energetic range of which is overlapped with that from the most energetic solar particles, although their fluence tendency is anti-correlated with the solar cycle.

Under solar disturbance conditions important changes are produced at all space scales of the terrestrial environment: magnetosphere, ionosphere, atmosphere, etc., and the effects are also detectable in the surface. One of the physical processes that take place when an interplanetary CME reaches the terrestrial magnetosphere, is the entry of particles inside thereof and the subsequent modification of the geomagnetic field, which is known as geomagnetic storm.

The effects the energetic particles, the electromagnetic radiation and the modification of the geomagnetic field produce in the terrestrial environment, are varied and with very different time scales. They can affect health either directly, for example, or indirectly through faults in the technology society uses daily, for example, in radio communication, terrestrial navigation and positioning systems, and even in critical infrastructures such as electric power grids, rail transport or large gas or oil pipelines between countries.

### Background

It is known that there are several contributions when making the magnetic field measurement, such as: that generated by the Earth itself by the inner dynamo effect, that generated by the usual solar activity (also referred to as *"Quiet Sun"*) and that generated by the solar phenomena mentioned above which take place sporadically. The object of the present invention is focused on measuring magnetic disturbances at middle latitudes, the determination and correct interpretation of which mainly faces two problems: one related to the "Quiet Sun" component and the other related to disturbances caused by the solar activity that take place irregularly.

The first problem is related to the magnetic field generated by the so called "Quiet Sun" component, produced by an equivalent system of ionospheric electric current which occurs at the dayside of the planet and which shows vorticity on a global scale, with one vortex being at each hemisphere and whose focal points are located at middle latitudes. This system does not remain fixed but it diverts in length and latitude throughout the day and shows a day to day variability which causes uncertainty in correctly determining both the intensity and the focal point position.

The second problem is caused because the magnetic disturbances produced by solar phenomena on the Earth's surface on a global scale, in the middle latitudes ranges, are well represented by global indicators being especially designed in this regard, this not being the case with local magnetic disturbances, wherein not knowing them may sometimes lead to mistaken interpretations, even to mixing them up with global effects. For example, it is deeply assumed that at middle/low latitudes (latitude ranges being approximately between 15º and 55º North and between 15º and 55º South), the only source capable of producing geomagnetic disturbances of significant intensity on a global scale, is that caused by the magnetospheric ring current, produced by the enhancement of the low energy particle population circulating around the Earth under adverse space weather conditions (Gonzalez, W. D., et al. "What is a geomagnetic storm?" Journal of Geophysical Research: Space Physics 99, A4 (1994): 5771-5792). However, recent publications (Cid, C., et al. "A Carrington-like geomagnetic storm observed in the 21st century." Journal of Space Weather and Space Climate 5 (2015): A16 and Saiz, E., et al. "Searching for Carrington-like events and their signatures and triggers." Journal of Space Weather and Space Climate 6 (2016): A6), demonstrate that at said middle latitudes there can exist local magnetic disturbances of significant intensity being very similar to, or even quite higher than, the disturbances caused by the ring current. These recent research results establish, with special importance, the role played by the local geomagnetic indices in the field of Space weather and create new requirements in the accuracy and reliability thereof.

The "Quiet Sun" component is determined by the contribution to the geomagnetic field of the equivalent system of ionospheric currents generated by a dynamo effect in the illuminated side of the Earth. It has a circulation pattern having a vortex at each Earth's hemisphere which diverts throughout the day, and the focal points thereof are located approximately in the middle latitude range near 40º, both in the North hemisphere and in the South hemisphere. This current system is usually identified monthly by means of the average of the five days of the month where there is less geomagnetic disturbance, which are internationally established (*IQD, International Quiet Days*). This representation and determination of the day-to-day variation of the quiet day is the one being currently used, but it has several drawbacks. When the purpose is to obtain the global disturbance, said drawbacks may be irrelevant, however, they acquire special importance when the final object is to obtain the geomagnetic disturbance located in an area or region (local geomagnetic index) as that of the present invention. The main drawbacks are mainly determined by three reasons:
a) The magnetic disturbance of an area may get to have important differences one with respect to the other and, therefore, the international definition of quiet time, which is based on a global index (*Kp* index), can lead to error when the geomagnetic disturbance only affects to a very localized area;
b) Determining the quiet days by using the Universal Time (*UT*) as the base time. Although that is used in the *IQDs,* it is not, by definition, a practical way of detailing a quiet day for a local area since, inevitably, the local day (with the base time being the local time (*MLT,* Magnetic Local Time)) will be displaced with respect to the universal time;
c) The inherent variability existing between quiet days, which makes the determination through the average of several days results in a representation of a local quiet day very different to the real one. Furthermore, for middle latitudes which are those of focal points location for this system of ionospheric currents, this problem is even more important.

The object of the present invention is the development of a method which, starting from the local geomagnetic field at middle latitudes, is capable of estimating the disturbance component due to phenomena associated to the sporadic solar activity. In order to do so, the problems described above are taken into account and specially those affecting the middle latitudes.

Background is known about devices and methods for predicting the variation of the local geomagnetic field, as that described in WO 2015/013499 A1. Additionally, "A neural network-based local model for prediction of geomagnetic disturbances" (Hans Gleisner and Henrik Lundstedt, 2001) discloses a study that shows how locally observed geomagnetic disturbances can be predicted from solar wind data with artificial neural network (ANN) techniques. *"*Decomposition of daily geomagnetic variations by using methods of natural orthogonal component" (Wen-Yao Xu, 2004) discloses a method of natural orthogonal components (NOC) which is utilized to decompose the daily magnetic variation, expressing the variation as a summation of the eigenmodes.

However, as it is set forth herein, the state-of-the-art techniques for treating the geomagnetic field measurements for obtaining local geomagnetic disturbance have significant differences with respect to those set forth in the present invention.

### DESCRIPTION OF THE INVENTION

The present invention describes a method and a device capable of obtaining the local geomagnetic disturbance component at middle latitudes from the magnetic field measurement on the Earth's surface. Said measurement must provide at least the horizontal component of the geomagnetic field on the Earth's surface and may be directly obtained from geomagnetic sensors duly calibrated and isolated from any artificial electromagnetic disturbance. Said measurement can also be obtained from the data the geomagnetic observatories provide in real time through remote connections.

There are mainly three components which can be included within the magnetic field measurement on the Earth's surface; an inner component, component I), in turn consisting of the main component, the origin of which is in the dynamo process occurring in the core, and a component due to the Earth's crust and mantle; a "Quiet Sun" component, component II), originated by the equivalent system of the day ionospheric currents; and a disturbance component; component III), caused by sources being external to the terrestrial environment, as it is that one irregularly and sporadically produced because of the solar activity.

The present invention refers to the determination of the first two components so as to obtain the third one, the local geomagnetic disturbance generated by the solar activity, with the object of being capable of predicting potential hazards as those listed in the *Technical Problem to be solved* section.

The technique used in the present invention determines, in the first place, the component II), which features variation (of a considerable magnitude, in the order of dozens of nanoteslas) of a shorter period of time (a day), as compared to periods in the order of months, or longer, of the component I). This method contrasts with the traditional method, where component I) is usually obtained in the first place, since it has slower variations. This is possible thanks to the method used in the present invention for obtaining the component II), which, by means of a quiet day behaviour model, is capable of univocally determining the daily variation curve for those days not being affected by external disturbances.

Furthermore, the correct determination of the component II) during a set of days extended in time, allows obtaining the component I). Although the component I) has slow variations, it is difficult to predict. There are geomagnetic models, such as the *IGRF* (*International Geomagnetic Reference Field*), which provides these components for values from the past, present and with some years projection towards the future (no more than five), but both its space and time accuracy, is not usually enough for many applications.

Consequently, in the present invention, the component I) is obtained from the measured data, not directly but after realizing part of the processing for obtaining the component II. This way to proceed provides the invention with two important characteristics, on the one hand, absolute independence from the method about external data, and on the other higher accuracy for obtaining the components for the concrete location of the measurement, since it does not depend on derived data with a global nature, as it would occur with the use of geomagnetic indices or models.

In order to determine the component II), as it has been mentioned, a fit to a quiet day model is made to the representative data of the day-to-day variation. In order to do that, a smooth tendency curve of the night values is previously obtained in an auxiliary manner, that is, a curve joining the values of the geomagnetic field measured in the night time, less affected by the day-to-day variation. By analysing the goodness of fit of the model to the data, an assessment of the geomagnetic quietness thereof is obtained, that is, it is possible to know when the data have a day-to-day variation curve representing a quiet day. This characteristic makes it possible to determine the component I) from the accumulation of those days classified as quiet days.

The component I) can be determined in several ways, for example by means of an interpolation curve of monthly or yearly average values of the geomagnetic quiet days being selected as described above. A variant can be to use as an alternative the official quiet days (International Quiet Days) internationally established by GFZ-Potsdam. Another variant can be to use the monthly or yearly average values of the geomagnetic observatories being nearest to the measured area.

The geomagnetic disturbance component III) (final object of the present invention), is obtained by eliminating the components I) and II) from the measured data. For the geomagnetic quiet days, wherein the model provides a good fit to the data, the component II) that must be removed is precisely the quiet daily variation curve obtained from the model fit. For the days in which the model fit is not good, there are several alternatives. It can be removed the daily variation curve of the quiet day being nearest in time, the average of several days or even no daily variation curve can be eliminated.

In the state of the art there are interpolation methods for geomagnetic measurement data, for example, in the document WO 2015/013499 A1, but the object is usually always to determine the component I), of a slower variation and less complexity than the daily variation curve at middle latitudes.

The innovative character of the present invention is possible thanks to the application of a quiet day model. Said model is defined by means of a smooth interpolation curve running through points which are fixed at a determined time position of the day. The model represents the geomagnetic variation undergone in the illuminated side of the Earth, the dayside, therefore two types of points are differentiated, those fixed to null intensity in the night time, (N) points, and those being free regarding intensity, in the dayside, (P) points, and providing the freedom degrees required for the model fit as parameters. For the daily variation curve to take any possible shape typical of middle latitudes, and at the same time, prevent the model from providing a good fit to other external disturbance geomagnetic variations that must be excluded, the (P) points must be four, be placed in the day hours (between 6h and 18h) and with a distance between them from one to three hours.

### DESCRIPTION OF THE DRAWINGS

To implement the present description being made and in order to provide a better understanding of the characteristics of the invention, a set of drawings is attached as integral part of said description, with an illustrative but not limitative purpose, which represents the following:
- Figure 1 shows in panel a) the time evolution of the horizontal component of the local geomagnetic field, component H, in a concrete period of time (from the 9^{th} to the 13^{th} of March of 2001), in a concrete location (San Pablo de los Montes observatory, Toledo, Spain) by way of example and it also includes the curves involved in the method object of the invention. In panel b) the figure shows the result of applying the method object of the invention, that is, the local geomagnetic disturbance component III);
- Figure 2 illustrates the flow diagram of the method for determining the local geomagnetic disturbance on the Earth's surface;
- Figure 3 is an enlarged detail of the data fitting to the quiet daily variation curve in a time interval of a day;
- Figure 4 represents a scheme of the device associated to the invention on one of the preferred embodiments thereof.

The following is a list with the different elements represented in the figures:
- 11 (solid line): horizontal component of the measured geomagnetic field;
- 12 (broken lines): calculated tendency curve of night values;
- 13 (broken line with thick hyphen): calculated daily variation curve of the horizontal component of local geomagnetic field;
- 14 (broken line with thin hyphen): base line associated to the horizontal component of the local geomagnetic field associated to the magnetic field generated in the Earth's inside area, crust and mantle;
- 15: magnetic disturbance of the horizontal component of the local magnetic field;
- 20: block of the flow diagram of the horizontal component pre-processing of the measured geomagnetic field;
- 21: block of the flow diagram for determining the daily variation curve;
- 22: block of the flow diagram for determining the base line;
- 23; block of the flow diagram for the final calculation that determines the local geomagnetic disturbance;
- 211: determining and obtaining the auxiliary tendency curve of the night values;
- 212: step for daily variation model fitting to the data from the previous step;
- 213: step for deciding whether or not determining the current data as belonging to a geomagnetic quiet day;
- 214: step for searching the geomagnetic quiet day being nearest to the current one in the data base 225, which is carried out after a negative response at 213;
- 225: data base of the geomagnetic quiet days saved after positive responses at 213;
- 226: step for calculating the base line;
- 31 (solid line): curve of the data to be fit to the quiet day model, calculated from the horizontal component of the magnetic field, and once the auxiliary tendency curve of the night values has been obtained;
- 32 (broken lines with a thick hyphen): daily variation curve obtained from the quiet day model fit;
- 331-334: control points of the cubic spline, (N) type, fixed in the time position (horizontal) and in intensity (vertical), of the quiet day model.
- 341-344: control points of the cubic spline, (P) type, fixed in the time position but free in intensity, of the quiet day model;
- 40: device for obtaining the local geomagnetic disturbance;
- 41: data input unit of the device 40;
- 42: device CPU 40;
- 43: data storage unit of the device 40;
- 44: data output unit of the device 40.

### DESCRIPTION OF AN EMBODIMENT OF THE INVENTION

As it is known, there are several contributions when measuring the magnetic field on the Earth's surface which, in certain situations, can be identified as three different components:
I) an inner component, consisting of the main component, the origin of which is in the dynamo process occurring inside the Earth, and a component due to the earth's crust and mantle;
II) a component of the "Quiet Sun", originated by the equivalent system of the dayside ionospheric currents;
III) a disturbance component, due to sources being external to the terrestrial environment, as that being irregularly and sporadically produced because of the solar activity.

The present invention refers to the determination of the first two components I), II) so as to obtain the local geomagnetic disturbance generated by the solar activity, component III), with the object of predicting situations being potential hazards as those listed in the *Problem to be solved* section.

### Global vision of the method

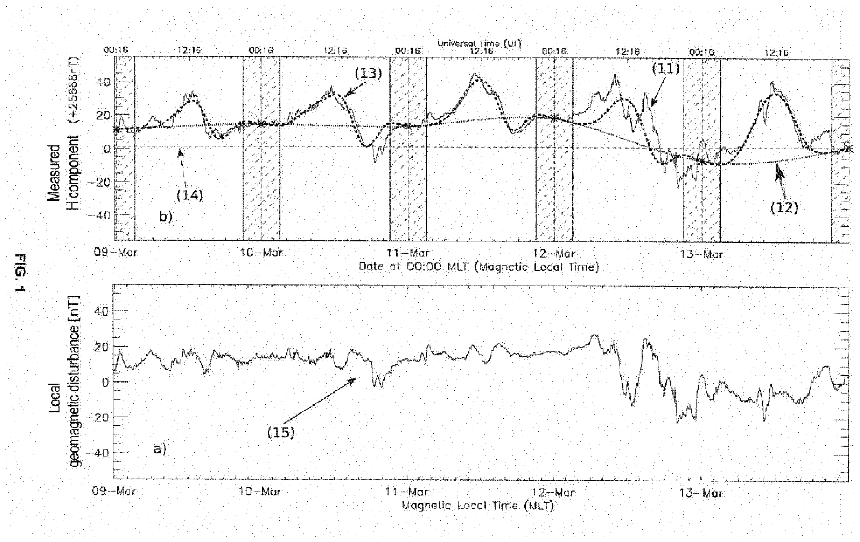

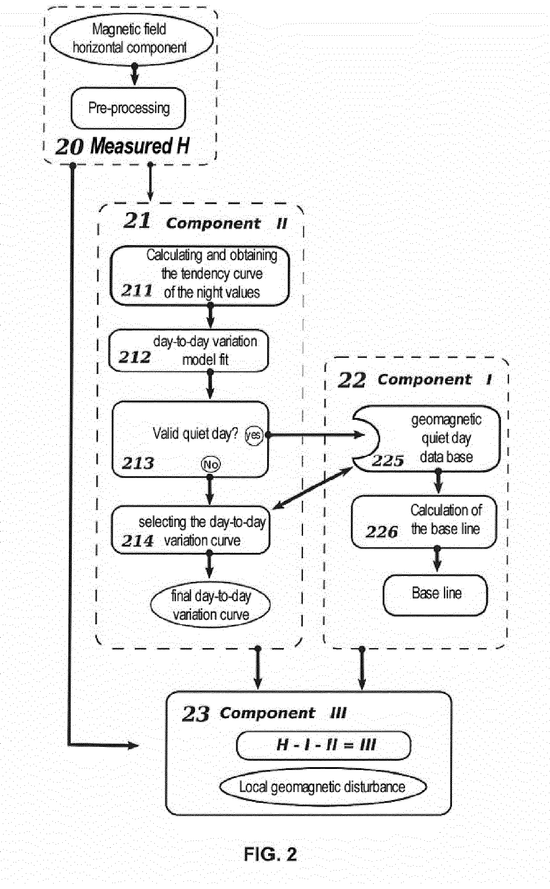

In order to provide a global vision and a better understanding of the method, figure 1 and 2 show the curves involved in the method and a flow diagram thereof, respectively.

Figure 1 represents, in the upper panel (1a) the evolution of the horizontal component of the measured local geomagnetic field, curve (11), together with the different curves involved in the method (12)-(14). The lower panel (1b) represents the result of applying the method described in the present invention, the curve (15). In the case of figure 1a, the measured data, represented with (11), have been provided by San Pablo de los Montes observatory in Toledo, Spain, by internationally identified with the acronym SPT (code provided by IAGA, International Association of Geomagnetism and Aeronomy). The number between brackets which appears in the axis of ordinates corresponds to the value (expressed in nanoteslas, *nT*) that has to added up to the values provided at the axis of ordinates in order to obtain the absolute value of the measurement. The lower axis of abscissas represents the time at which the measurement is performed, provided in the Magnetic Local Time (*MLT*). The upper axis of abscissas represents time expressed in terms of Universal Time (UT). The 16 minutes difference being appreciated between both time scales corresponds to the time difference being equivalent to the difference between the reference geographic length of the Greenwich meridian and the SPT observatory length where the measurement is performed. The time window of figure 1 has a length of five days.

Figure 2 shows the flow diagram of the whole method. As it can be observed, there is an initial block (20), two main blocks or sub-methods vertically oriented (21) and (22), and a final block (23). The main blocks carry out with the determination of component II) in block (21) and determination of component I) in block (22). The final block (23) is no more than a subtraction of the components I) and II), resulting from (21) and (22), from the component H of the measured data.

The first block (20) is a pre-processing of the measured data where, among other operations, an association is made of the values to the time reference thereof in the magnetic local system MLT. For that purpose, it is necessary that the measurement of the geomagnetic field is performed together with some time reference of when the measurement is realized, as it can be Universal Time (UT). To realize the conversion to MLT time, it is necessary to provide the position in terms of length of the place where the measurement has been realized. Likewise, the pre-processing includes transforming the coordinate system, if necessary, from the field components provided by the measuring system into a format from which it is possible to obtain the horizontal component (H).

The measured local geomagnetic field evolution, provided by the curve (11) from figure 1, involves the overlapping of the three components: I), II) and III) mentioned above. For obtaining how much from that value corresponds to the geomagnetic disturbance component (component III)), locally measured in a concrete point of the geography, and due to external sources, that is, as a consequence of the sporadic solar activity, it is necessary to eliminate components I) and II) described above. Figure 1a) also represents other three curves: (12) is the auxiliary tendency curve of the night values, used in block (211); (13) is the daily variation curve (component II)), and (14) is the base line representing the component I).

The technique used in the present invention determines in the first place the component II) since it is the one showing variation (of a considerable magnitude) of the shortest period (a day), against periods of the order of months or longer than the component I). Furthermore, the correct determination of the component II) during a long set of days, allows obtaining component I). Although component I) shows slow variations, its behaviour is difficult to predict. There are geomagnetic models, as *IGRF* model, that provide these components for values from the past, present and with some years projection towards the future (no more than five), but both their space and time accuracy is not usually enough for many applications. Also, these models are obtained from processes where the external disturbance component (component III) has been removed by means of a global interpretation thereof, for example, by using indices indicating geomagnetic disturbance not being local but global, as *Dst* index or *Kp* index. Therefore, when the purpose is to obtain the local geomagnetic disturbance accurately, as in the present invention, it is not suitable to use said geomagnetic models. As a consequence, in the present invention, the component I) is obtained from the data observed in the same location area where the measurement is realized. This characteristic can be better appreciated observing the flow diagram of figure 2; the component I, obtained in block (22), is obtained from the original measured data (20), not directly but after realizing part of the processing for obtaining the component II in block (21). This way of proceeding provides the invention with two important characteristics, on the one hand, absolute independence from the method on external data, and on the other higher accuracy for obtaining the components for the concrete location of the measurement, as it does not depend on the derived global data, as it would be the case with the use of indices or geomagnetic models.

### Quiet day model

The quiet daily variation component II) is determined thanks to a quiet day model (relative to the geomagnetic field horizontal component), valid for a magnetic latitude near the latitude of the focal point of the ionospheric currents system (approximately between 35º and 45º from the equator in both hemispheres), of the present invention. The model is characterized in that it is defined by means of a cubic spline, that is, a differentiable curve defined at sections by means of cubic polynomial (third grade polynomial). The control points are the joining place of the sections and the place where certain conditions are imposed making the transition occur smoothly. For a cubic spline, said conditions are three and they must be met in each control point. These three conditions involve continuity of the functions in the control points. The three conditions mean that the polynomial, the first derivative and the second derivative, all evaluated at the control points, must be the same at each side of the control point.

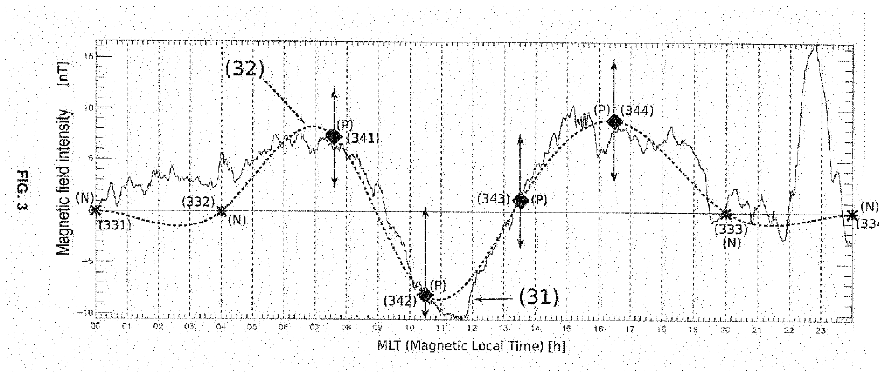

The quiet day model for this embodiment of the present invention consists of eight control points being distributed in time along a day, 24 hours, in a fixed manner at certain hours of the day, as it is shown in figure 3, represented by diamonds and asterisks, thus differentiating two types, parametrical (P) and neutral (N), respectively. Figure 3 shows said points in an example of geomagnetic quiet day; the data shown as the element (31) have been fit according to the daily variation model, thus obtaining the curve (32). The data shown in (31) are not the original ones being measured, resulting from block (20), but instead an auxiliary curve has been previously obtained in step (211) as it is described in the following section. The four (N) points correspond to two points in the first four hours of the day and other two points in the last four hours of the day, that is, occupying the local night hours (hence them being referenced with the letter N). These (N) points are characterized in that they are situated at a magnetic field intensity fixed on a zero value with respect to the base value of the quiet day model. The rest four control points, (P) points, are located at the central area, corresponding to the hours of the day in the place, and these are characterized by having a variable intensity, each providing a free parameter to the model which allows fitting the data thereto. Furthermore, in the two (N) points at the ends (those corresponding to 0 h and 24 h), the condition that the first derivative is null is imposed. The model thus defined has four freedom grades, due to the four free parameters (P) of the central area in the day hours.

### Determination of the auxiliary tendency curve of the night values

Since we start from the observational data being measured on the Earth's surface (that, as described above, result from overlapping four components), in order to realize a quiet day model fit with the object of obtaining component II), the data to which it is fit must contain the minimum contribution of the other two remaining components; I) and III). The technique being adopted in the invention is to first determine an approach of the two components I) and III) being overlapped, which are obtained from the original data in an auxiliary manner, and which allows realizing a quiet day model fit only to those daily variation values which best represent the component II). This approach curve, which has been referred to as tendency curve of the night values (element (12) in figure 1b), is an smooth interpolation curve between a single day point obtained from the average value of the night hours, described in further detailed bellow.
1. In order to understand the importance and also the validity of the determination of the auxiliary curve, there has to be taken into account the possible behaviour of the other two components. Component I), as it was already said, has slow variations as compared to the daily variations and, therefore, an assessment of this type with a single day point (representing the average value of the night zone), is more than enough for ensuring its correct description. The external disturbance component III) contemplates geomagnetic variations of very different nature, which for the purposes of the present invention can be differentiated into two types: III-A) important intensity variations which disturb the magnetic field in an irregular and sporadic manner, difficult to predict and preventing a correct determination of the daily variation component II); and III-B) smooth variations but sustained, of more than one day long and which can be present in a geomagnetic quiet day, due to disturbances in the previous days. Type III-A) variations show fast and important changes resulting in a non-valid quiet day model fit, and therefore, although a determination thereof is not possible, the presence thereof can be established by measuring the goodness of fit, as it will be seen bellow. III-B) variation is translated into an increase, or smooth reduction, of the daily level of the measured geomagnetic field, and thus assessment by means of a curve obtained by a day point also ensures the correct determination thereof prior to the fit.

At this point, it has to be clarified that determining, prior to the quiet day model fit, the tendency curve (12) as an approach of the components I) and III-B), does not mean that said variation will be definitely eliminated from the original observational data, since, as it will be seen bellow, this is only used as an auxiliary curve for determining the daily variation component. In order to clarify the following terminology being used, a differentiation should be done between *removal,* a term intended to indicate the definite subtraction operation of a contribution and with which the intermediate or final result is obtained; and the term *subtraction,* indicating that the subtraction arithmetic operation is done, but only as an intermediate process not implying the definite elimination over the original data.

The auxiliary tendency curve of the night values (12) is obtained from the average value reached in a set of night hours which is previously chosen from a symmetric range (a maximum of 4 hours) of hours being before and after local midnight as a transition between a day and the next one. In the case of the example for five days shown in figure 1b), the average values for the six night hours are represented by asterisks, the night hours area being used, from -3h to +3h with respect to local midnight, are marked with an oblique-lined background. The smooth curve passing over those average night values has been realized by means of a cubic spline, although other similar smooth curve interpolation methods can be used. Once the tendency curve of the night values is determined, this is obtained from the measured data and the quiet day model fit is performed on the subtraction result.

### Classification and storage of geomagnetic quiet days

The quiet day model fit to the data can be realized by minimizing a function as that of the mean squared error and assessing the goodness of fit by chi-squared test. The method used is an iterative process wherein initial values are established for the four parameters thereof and the goodness of fit is assessed. In the process, the parameters towards the value that minimized the error function are modified, such that these must converge towards a stable value provided that the data have a typical daily variation of a geomagnetic quiet day. The iterative method can be finished by a number of iterations (if not converging) or by establishing a threshold in the relative increment of the goodness of fit value between an iteration and the following, such that for increments lower than the threshold, it ensures the end of the convergence process thereof.

The final value of the goodness of fit (*chi-squared* value) is used in this step (213), see figure 2, so as to discriminate whether or not it is a quiet day. If the value is sufficiently high it indicates that the fit is not good, probably because the data have geomagnetic disturbance and, therefore, it cannot be considered as a quiet day. The curve thus determined must not be used as component II). On the other hand, the result with a small *chi-squared* value confirms that the curve resulting from the fit is a valid curve of a quiet day and, therefore, not only it should be removed as component II), but also it must be stored in a data base (step (225) in figure 2) that will allow determining the component I).

In order to realize this discrimination adequately, a threshold value is established for the goodness of fit, which can be determined in several ways depending on the quantity of previously known data. If historical data are provided continuously for several years, it is possible to realize a study of the probability distribution of the *chi-squared* being obtained for the model fittings to each day and establish the threshold in a value being high enough as to ensure a probability near zero of finding a quiet day for values above that threshold. If there are no continuous historical data but there is a period of several days, in order to establish the threshold a comparative study can be done of the value of the goodness of fit between quiet and disturbance days.

In the most unfavourable case that no previous data is provided, it is known that the quiet day model being described in the present invention has four grades of freedom, therefore, the theoretical *chi-squared* distribution, assuming only quiet days with a normal error distribution, may serve as a reference for establishing the threshold in a value which indicates a probability to find a quiet day higher than 99.9%.

In the particular case of the present embodiment of the invention, the threshold has been obtained from the *chi-squared* distribution function resulting from data fitting from 1997 up to 2012; establishing the threshold in 40.

When a goodness of fit value exceeds an established threshold, as it has been said above, the curve being obtained in the fit should not be used as representative of a quiet day, since it indicates the presence of geomagnetic disturbance. This does not involve the non-existence of a daily variation component, since this is always present, and, therefore, another alternative curve must be used (step (214) of the method of figure 2). One of the most widely used methods is that of averaging several quiet days being representative of the month (the *IQDs* or other being equivalent, selected from the observatory data), but as it was described above, this is not the best option to take due to the day to day variability that the daily variation curves may show, especially at the latitudes for which the present invention is used. The daily variation curve to be used alternatively involving a lower error probability, is the valid quiet day curve being the nearest in time. As it can be appreciated at first sight in figure 1b), the 12^{th} of March shows a disturbance component being higher than that of the rest of days, the quiet day model fit for this day resulting in a *chi-squared* value higher than the threshold and, therefore, the previous day curve has been considered as a valid daily variation curve, which was classified as a quiet day because of the goodness of fit thereof, as it can be appreciated at first sight when comparing the curves (11) and (13) in figure 1b).

### Determination of the component I)

As it has been mentioned above, the component I) has slow variations, in the order of a few nanoteslas (nT) in a period longer than a month and, thus, these can be removed altogether since they show periodicities much higher than the one of interest, which is a day long. The method used for that is by generating a smooth interpolation curve, base line, passing across points being separate at a time distance. With the object of taking under consideration, if desired, magnetic variations having long periodicities (seasonal, annual, cyclic, etc.), it is considered that the minimum time distance between points should be at least a month, although other longer distances can be chosen.

The values of the points through which said base line runs may be obtained from the mean values of the time interval being considered. These mean values can be obtained in different ways. In their main way of operation, these are calculated from the geomagnetic quiet days being classified as valid and stored in the data base (225) as a product of step (213). In the case of figure 1b), the base line thus obtained with annual values is shown as an element (14). In case there are not enough elements being provided in the data base (225) due to, for example, a first operation of the device, there can be used the official mean values from the geomagnetic observatories, or, alternatively, the mean values calculated from those provided by geomagnetic models such as the *IGRF.*

### Determination of the geomagnetic disturbance

Once the base line (14) is determined, being representative of component I), resulting from the block (22) of figure 2, and the daily variation (13), representative of component II), obtained as a result of block (21), these are removed from the pre-processed measured data so as to obtain the value of the local geomagnetic disturbance, component III), represented in figure 2 as block (23).

### Device for the method implementation

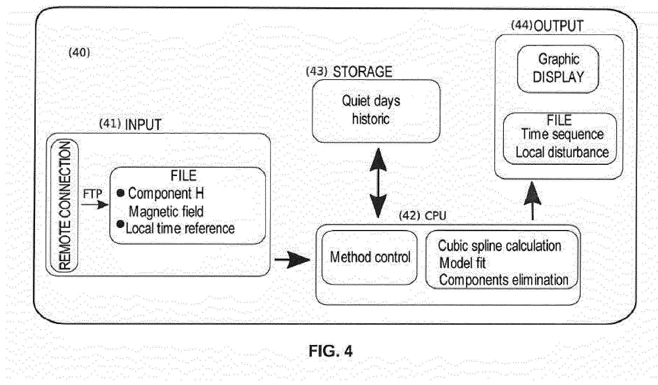

The method described in the present invention can be implemented, for example, in a device as that shown in figure 4 as element (40). The input data (41) are obtained by means of a remote connection to files which can be updated in real time and containing the horizontal component of the geomagnetic field measured at least by two magnetic sensors duly aligned in the horizontal plane. The sensors may be of the *fluxgate* type and the measurement must be stable in time and isolated from interferences by external technology.

Furthermore, there has to be a register of the magnetic local reference time, for which it is necessary to know at least the Universal Time (UT) when each measurement is performed, and the geomagnetic longitude of the measuring point. The data can be directly input into a text file with the data being updated with the most recent measurement.

The device (40) has a control and process unit (42), CPU, of the method described in the present invention. The calculation unit must be capable of calculating mean values, arithmetic difference of data vectors (curves), calculating cubic *spline* and calculating mean squared error and *chi-squared.* The process unit must be capable of implementing the procedure shown in figure 2 and, therefore, it must be capable of executing *if* type control commands for step (213) and *for* loops for the iterative processing of the quiet day model fit of step (212). Furthermore, for the data base described as step (225) a data storage system (43) is used to which the control unit can have access at any moment.

Finally, the geomagnetic disturbance data of the local horizontal component can be output (44) into text files and images keeping the last update, and, at the same time, to a screen showing a graph with them.

It should be noted and understood that there can be improvements and modifications made of the present invention described above without departing from the scope of the invention as set forth in the accompanying claims.

## Claims

1. Method for obtaining local geomagnetic disturbance (15) at middle latitudes, comprising the steps of:
a) obtaining the measurement of the local horizontal geomagnetic field (11), by treating the original data provided by the magnetic sensors in the magnetometer located at the Earth's surface;
b) determining a daily variation curve (13), representing the ionospheric origin contribution of the geomagnetic field horizontal component measured on the Earth's surface;
c) determining a base line curve (14), representing the magnetic field contribution associated to the Earth's core, crust and mantle of the geomagnetic field horizontal component measured on the Earth's surface;
d) obtaining the local geomagnetic disturbance (15) as a result of removing from the horizontal component of the measured local geomagnetic field (11), the ionospheric contribution (13) values and the contribution values of the Earth's core (14);
**characterized in that** for obtaining the daily variation curve (13), an analysis is performed, even in real time, to determine if there is a quiet day or a disturbed day, with the following method:
1) an auxiliary tendency curve of the night values (12) is determined;
2) the tendency curve of the night values (12) is subtracted from the horizontal component of the measured magnetic field (11);
3) a quiet day model (212) is fit to the data obtained in step 2), the geomagnetic quiet day model being defined by means of a cubic spline curve with four variable intensity control points which work as free parameters, and which are located with a fixed separation between them, encompassing all the local day hours, and with four control points having a zero-value intensity for all the local night hours;
4) classifying the data, from values of the goodness of fit performed in step 3) and with the thresholds being established according to each case, as those of a geomagnetic quiet day or those of a disturbed day;
5) the fit data from the quiet day model are established, for those days classified as quiet day, as the daily variation curve.

2. Method for obtaining local geomagnetic disturbance (15) at middle latitudes, according to claim 1, **characterized in that** the contribution from the Earth's inside area (14) is determined through a mean value of the data existing in a data base of the method of days being previously classified as quiet.

3. Method for obtaining local geomagnetic disturbance (15) at middle latitudes, according to claim 1 or 2, **characterized in that** the daily variation curve (13), used for a day classified as disturbed, is the daily variation curve of the day classified as quiet being the nearest in time.

## Patentansprüche

1. Verfahren zum Erhalten einer lokalen geomagnetischen Störung (15) in mittleren Breiten, umfassend die folgenden Schritte:
a) Erhalten der Messung des lokalen horizontalen geomagnetischen Feldes (11) durch Behandeln der Originaldaten, die von den Magnetsensoren in dem an der Erdoberfläche befindlichen Magnetometer bereitgestellt werden;
b) Bestimmen einer täglichen Variationskurve (13), die den ionosphärischen Ursprungsbeitrag der auf der Erdoberfläche gemessenen horizontalen Komponente des Erdmagnetfelds darstellt;
c) Bestimmen einer Grundlinienkurve (14), die den Magnetfeldbeitrag darstellt, der dem Erdkern, der Erdkruste und dem Erdmantel der auf der Erdoberfläche gemessenen horizontalen Komponente des Erdmagnetfelds zugeordnet ist;
d) Erhalten der lokalen geomagnetischen Störung (15) als Ergebnis des Entfernens der gemessenen Werte des ionosphärischen Beitrags (13) und der Beitragswerte des Erdkerns (14) aus der horizontalen Komponente des gemessenen lokalen geomagnetischen Feldes (11);
**dadurch gekennzeichnet, dass** zum Erhalten der täglichen Variationskurve (13) eine Analyse auch in Echtzeit durchgeführt wird, um zu bestimmen, ob ein ruhiger Tag oder ein gestörter Tag vorliegt, mit dem folgenden Verfahren:
1) Bestimmen einer Hilfstendenzkurve der Nachtwerte (12);
2) Subtrahieren der Tendenzkurve der Nachtwerte (12) von der horizontalen Komponente des gemessenen Magnetfeldes (11);
3) Anpassen eines Modells für einen ruhigen Tag (212) an die in Schritt 2) erhaltenen Daten, wobei das geomagnetische Modell für einen ruhigen Tag mittels einer kubischen Spline-Kurve mit vier Kontrollpunkten variabler Intensität definiert wird, die als freie Parameter arbeiten und sich mit einem festen Abstand zwischen ihnen befinden, die alle lokalen Tagesstunden umschließen, und mit vier Kontrollpunkten mit einer Intensität von Null für alle lokalen Nachtstunden;
4) Klassifizieren der Daten aus Werten der in Schritt 3) durchgeführten Anpassungsgüte und wobei die Schwellenwerte jeweils als diejenigen eines geomagnetischen ruhigen Tages oder diejenigen eines gestörten Tages erstellt werden;
5) Erstellen der Anpassungsdaten aus dem Modell für einen ruhigen Tag für die als ruhiger Tag klassifizierten Tage als tägliche Variationskurve.

2. Verfahren zum Erhalten einer lokalen geomagnetischen Störung (15) in mittleren Breiten nach Anspruch 1, **dadurch gekennzeichnet, dass** der Beitrag aus dem Erdinneren (14) durch einen Mittelwert der Daten bestimmt wird, die in einer Datenbank des Verfahrens der Tage vorhanden sind, die zuvor als ruhig klassifiziert wurden.

3. Verfahren zum Erhalten einer lokalen geomagnetischen Störung (15) in mittleren Breiten nach Anspruch 1 oder 2, **dadurch gekennzeichnet, dass** die tägliche Variationskurve (13), die für einen als gestört klassifizierten Tag verwendet wird, die tägliche Variationskurve des als ruhig klassifizierten Tages ist, der am zeitnächsten ist.

## Revendications

1. Procédé d'obtention de la perturbation géomagnétique locale (15) aux latitudes moyennes, comprenant les étapes consistant à :
a) obtenir la mesure du champ géomagnétique horizontal local (11), en traitant les données d'origine fournies par les capteurs magnétiques dans le magnétomètre situé à la surface de la Terre ;
b) déterminer une courbe de variation journalière (13), représentant la contribution d'origine ionosphérique de la composante horizontale du champ géomagnétique mesuré à la surface de la Terre ;
c) déterminer une courbe de ligne de base (14), représentant la contribution du champ magnétique associée au noyau, à la croûte et au manteau terrestres de la composante horizontale du champ géomagnétique mesuré à la surface de la Terre ;
d) obtenir la perturbation géomagnétique locale (15) résultant de l'élimination de la composante horizontale du champ géomagnétique local mesuré (11), des valeurs de contribution ionosphérique (13) et des valeurs de contribution du noyau terrestre (14) ;
**caractérisé en ce que** pour obtenir la courbe de variation journalière (13), une analyse est effectuée, y compris en temps réel, pour déterminer s'il y a une journée calme ou une journée perturbée, avec le procédé suivant :
1) une courbe de tendance auxiliaire des valeurs de nuit (12) est déterminée ;
2) la courbe de tendance des valeurs de nuit (12) est soustraite de la composante horizontale du champ magnétique mesuré (11) ;
3) un modèle de jour calme (212) est ajusté aux données obtenues à l'étape 2), le modèle de jour calme géomagnétique étant défini au moyen d'une courbe spline cubique avec quatre points de contrôle d'intensité variable qui fonctionnent comme des paramètres libres, et qui sont situés avec une séparation fixe entre eux, englobant toutes les heures de jour local, et avec quatre points de contrôle ayant une intensité de valeur nulle pour toutes les heures de nuit locale ;
4) classer les données, à partir des valeurs de qualité d'ajustement effectué à l'étape 3) et avec les seuils étant établis selon chaque cas, comme celles d'une journée calme géomagnétique ou celles d'une journée perturbée ;
5) les données d'ajustement du modèle de jour calme sont établies, pour ces jours classés comme jour calme, comme la courbe de variation journalière.

2. Procédé d'obtention de la perturbation géomagnétique locale (15) aux latitudes moyennes, selon la revendication 1, **caractérisé en ce que** la contribution de la zone intérieure de la Terre (14) est déterminée par une valeur moyenne des données existantes dans une base de données du procédé de jours étant précédemment classés comme calmes.

3. Procédé d'obtention de la perturbation géomagnétique locale (15) aux latitudes moyennes, selon la revendication 1 ou 2, **caractérisé en ce que** la courbe de variation journalière (13), utilisée pour une journée classée comme perturbée, est la courbe de variation journalière de la journée classée comme calme étant la plus proche dans le temps.
